# EUROPEAN PATENT APPLICATION

(11) **EP 0 595 318 A2**
(43) Date of publication of application: **04.05.1994**
(21) Application number: 93117493.2
(22) Date of filing: 28.10.1993
(51) Int. Cl.: H03K 19/0185, H03K 19/00, H03K 19/017

(54) **Buffer circuit for input signal having amplitude smaller than power voltage**

(30) Priority: 30.10.1992 JP 293216/92
(71) Applicant: NEC CORPORATION, Tokyo (JP)
(72) Inventor: Tsukada, Shyuichi, Minato-ku, Tokyo (JP)
(74) Representative: Betten & Resch

(57) **Abstract**

A buffer circuit for an input signal having a logical amplitude different from a power supply voltage is disclosed, which includes an inverter circuit composed of a P-channel transistor (Q2) and an N-channel transistor (Q1) connected in series between power supply terminals. This circuit further includes a first transistor of a diode-connected type (Q3) inserted between at least one of the P-channel and N-channel transistors (Q2,Q1) and the corresponding power supply terminal and a second transistor (Q4) connected in parallel to the first transistor (Q3) and driven by a signal having a phase opposite to the signal from the inverter circuit.

## Description

### BACKGROUND OF THE INVENTION

The present invention relates to a buffer circuit and, more particularly, to such a circuit having P-channel and N-channel MOS transistors connected in series between power supply terminals.

A buffer circuit is used for buffering and wave-forming an input signal. A CMOS inverter is typically employed as a buffer circuit in a digital circuit. This inverter includes a P-channel MOS transistor and an N-channel MOS transistor connected in series between power supply terminals, and the input signal is supplied in common to the gates of the transistors. As is well known in the art, the CMOS inverter consumes a power only during a transition period in logic level of the input signal and substantially no power during a steady period in logic level thereof, if the input signal has an logic amplitude equal to a power voltage applied between the power terminals.

However, the CMOS inverter is often required to buffer an input signal supplied from a differential amplifier. In this case, the power consumption does not become zero even when the input signal is steady in logic level. This is because the signal from the differential amplifier has a logic amplitude different from the power voltage.

Referring to Fig. 1A, a differential amplifier 10 is provided to amplify a potential difference between input nodes R and Ro. This amplifier 10 includes three N-channel MOS transistors Q5-Q7 and two P-channel MOS transistors Q8 and Q9 which are connected as shown. The output node A of the amplifier 10 is connected to a buffer circuit 20 composed of two CMOS inveters 21 and 22. The inverter 21 consists of an N-channel MOS transistor Q1 and a P-channel MOS transistor Q2, and the inverter 22 consists of an N-channel MOS transistor Q22 and a P-channel MOS transistor Q23. Such a circuit configuration as described above is often used as a data amplifier circuit for a memory circuit. That is, the input nodes R and Ro are coupled to a selected bit line pair to receive therethrough a potential difference relative to data stored in a selected memory cell. Thus, a data signal indicative of the data stored in the selected memory cell is derived from an output node C.

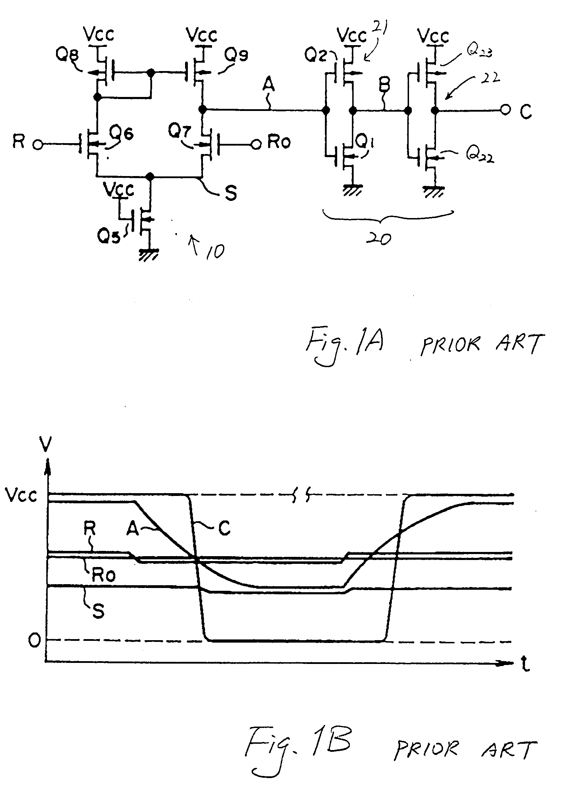

In operation, when the potential level at the input node R is higher than that at the input node Ro, as shown in Fig. 1B, the transistors Q6 and Q7 are rendered conductive and non-conductive, respectively, since they constitute a differential circuit. the conductive state of the transistor Q6 causes the transistors Q8 and Q9 to be turned on, so that the node A takes the power voltage level Vcc. The transistor Q1 is thereby turned on and the transistor Q2 is turned off. Thus, the output node C is driven to the power voltage Vcc. When the potential at the node R becomes lower than that at the node Ro, the transistor Q7 is in turn rendered conductive, and the transistors Q6, Q8 and Q9 are rendered non-conductive. The node A is thereby discharged by the transistors Q7 and Q5. It is to be noted that the node A is not discharged up to the ground level. Because of the existence of the transistor Q5, the discharged level at the node A is clamped at such a potential level that is lower than the potential level at the input node Ro by the threshold voltage of the transistor Q7. This discharged level at the node A is apparently higher than the threshold level of the transistor Q1. For this reason, both the transistors Q1 and Q2 are rendered conductive to thereby consume a d.c. power.

In order to reduce such a power consumption, the transistors Q1 and Q2 are required to have large conductance. That is, the transistors Q1 and Q2 is made large in gate length. This results in increase in gate stray capacitance. The node A thus have a relatively large stray capacitance. For this reason, the charging and discharging time constants of the node A are made large as shown in Fig. 1b. An operation speed is thereby lowered.

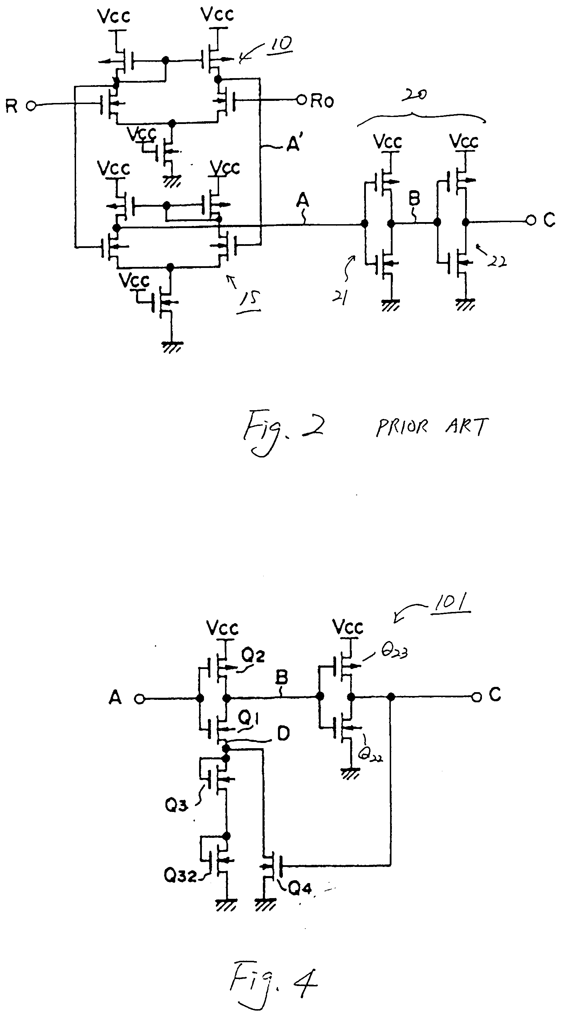

If such a circuit is constructed that discharges the node A up to a level that is lower than the threshold voltage of the transistor Q1, the above-mentioned drawback can be solved. Based upon this, as shown in Fig. 2, it is proposed to insert an additional differential amplifier 15 between the differential amplifier 10 and the buffer circuit 20. The amplifier 15 receives the output signal from the amplifier 10, so that the node A can be discharged to a such level that turns the transistor Q1 off. in this case, however, the power consumption is not substantially reduced, because two amplifiers are required. If the current flowing through the current source transistor Q5 of each amplifier is made small, the power consumption can be reduced; however, the operation speeds of the differential amplifier 10 and 15 are in turn lowered.

### SUMMARY OF THE INVENTION

It is therefore an object of the present invention to provide an improved buffer circuit for buffering a signal having logic amplitude smaller than a power voltage.

Another object of the present invention is to provide a buffer circuit receiving an input signal which has a logic amplitude smaller than a power voltage and producing an output signal which has a logic amplitude substantially equal to the power voltage without lowering an operation speed and consuming a large power.

A buffer circuit according to the present invention comprises a first transistor connected between a first power terminal and a circuit node and having a gate supplied with an input signal, a second transistor connected between the circuit node and a second power terminal and having a gate supplied with the input signal, a voltage drop element having a threshold voltage and inserted between the first transistor and the first power terminal, a switching element coupled in parallel to the voltage drop element, and a drive circuit driving the switching element by a signal having a phase opposite to the phase of a signal derived from the circuit node.

With such a circuit construction as described above, the voltage drop element turns the first transistor off against the input signal having one logic level which is different from the voltage at the first power terminal, so that substantially no power is consumed when the input signal stays at the one logic level. When the input signal takes the other logic level, on the other hand, the switching element is rendered conductive to mask the voltage drop element. The circuit node thereby assumes the voltage substantially equal to the voltage at the first power terminal.

### BRIEF DESCRIPTION OF THE DRAWINGS

The above and other objects, advantages and features of the present invention will be more apparent from the following description taken in conjunction with the accompanying drawings, in which
Fig. 1A is a circuit diagram illustrative of a circuit according to prior art;
Fig. 1B is a timing chart representative of an operation of the circuit shown in Fig. 1A;
Fig. 2 is a circuit diagram illustrative of a circuit of another prior art;
Fig. 3A is a circuit diagram illustrative of a first embodiment according to the present invention;
Fig. 3B is a timing chart representative of an operation of the circuit shown in Fig. 3A;
Fig. 4 is a circuit diagram illustrative of a second embodiment according to the present invention;
Fig. 5A is a circuit diagram illustrative of a third embodiment according to the present invention; and
Fig. 5B. is a timing chart representative an operation of the circuit shown in Fig. 5A.

### DETAILED DESCRIPTION OF THE PREFERRED EMBODIMENTS

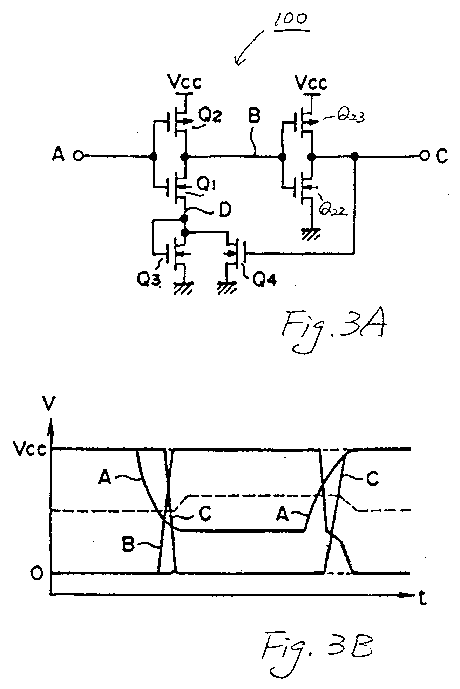

Referring now to Fig. 3A, a buffer circuit 100 according to a first embodiment of the present invention includes a P-channel MOS transistor Q2 and an N-channel MOS transistor Q1 receiving in common at the gates thereof an input signal supplied to an input node A. Unlike the circuit shown in Fig. 1A, this circuit 100 further includes, as a voltage drop element, an N-channel MOS transistor Q3 inserted between the transistor Q1 and the ground power terminal. The transistor Q3 has a gate connected to a drain thereof to operate as a diode. The node B of the transistors Q1 and Q2 is connected to an output node C through an inverter composed a P-channel MOS transistor Q23 and an N-channel MOS transistor Q22. The output node C is further connected to the gate of an N-channel MOS transistor Q4. This transistor Q4 is connected in parallel to the transistor Q3 as a switching element. Thus, this buffer circuit 100 is constituted for the input signal having a logic high level which is substantially equal to the power voltage Vcc and a logic low level which is different from the ground voltage by a level larger one threshold voltage but smaller than two threshold voltages.

When the input signal at the node A is at the logical high level, as shown in Fig. 3B, the transistor Q2 is rendered non-conductive, whereas the transistor Q1 is rendered conductive. The node B is thereby discharged to cause the inverter of the transistors Q22 and Q23 to turn the transistor Q4 on. That is, the transistor Q3 is masked and the node D of the transistors Q1 and Q3 substantially takes the ground level. Accordingly, the node B is discharged up to the ground level to turn the transistors Q23 and Q22 on and off, respectively, and the output signal at the node C takes the power voltage Vcc as a logical high level, as shown in Fig. 3B.

When the input signal at the node A is changed to the logical low level, the transistor Q2 is turned on to charge the Node B. The node C is thereby discharged to change the output signal to the low level. The transistor Q4 is thereby turned off. Thus, although the input signal at input node A is changed up to such a logical low level as described above, the transistor Q3 maintains the transistor Q1 in the non-conductive state. Therefore, no power is consumed in the circuit composed of the transistors Q1-Q3. The node B is thus charged up to the power voltage Vcc and the output signal at the node C takes the ground level as the logical low level thereof, as shown in Fig. 3B.

Since substantially no power is consumed when the input signal is steady in logical level, both the transistors Q1 and Q2 can be made with a large conductance, i.e., with a short gate length. The stray capacitance at the input node A is thereby small to perform a high operation speed. Accordingly, the buffer circuit 100 can be used for the circuit 20 shown in Fig. 1A, and in this case a high speed data amplifier is realized for a memory circuit.

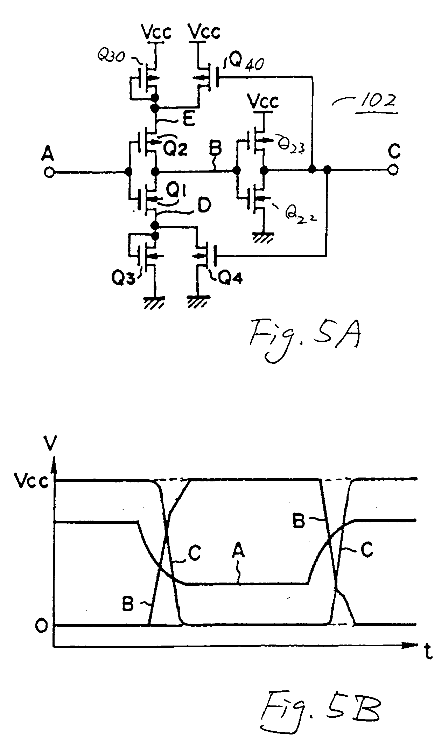

Turning to Fig. 4, a buffer circuit 101 according to a second embodiment of the present invention further includes an N-channel MOS transistor Q32 in addition to the circuit elements of the buffer circuit 100 of Fig. 3A. The transistor Q32 is connected in series between the transistor Q3 and the ground terminal and having a gate connected to a drain thereof. Accordingly, the buffer circuit 101 is provided for an input signal having such a logical low level that is different from the ground voltage by a level larger than two threshold voltages but smaller than three threshold voltages. The operation thereof is the substantially same as the circuit 100 of Fig. 1A.

The input signal often takes such a logical high level that is lower than the power voltage level Vcc by a level above the threshold voltage. A buffer circuit buffering such an input signal is shown in Fig. 5A as a third embodiment of the present invention. This buffer circuit 101 further includes two P-channel MOS transistors Q30 and Q40 in addition to the circuit elements of the circuit 100 (Fig. 3A). The transistor Q30 is connected between the transistor Q2 and the power terminal as a diode, and the transistor Q40 is connected in parallel to the transistor Q30 and driven by the output signal at the node C. As is apparent from the timing chart shown in Fig. 5B, this buffer circuit 101 produces the output signal having a logical high level equal to the power voltage Vcc and the logical low level equal to the ground voltage without lowering an operation speed thereof. Moreover, substantially no power is consumed during the steady state in logical level of the input signal.

It is apparent that the present invention is not limited to the above embodiments but may be modified and changed without departing from the scope and spirit of the invention. For example, each of the transistors Q3, Q32 and Q30 can replaced with a PN junction diode. The output signal can be derived from the node B in place of the node C.

## Claims

1. A buffer circuit comprising a first node supplied with an input signal, a first transistor connected between a first power terminal and a second node and having a gate connected to said first node, a second transistor connected between said second node and a third node having a gate connected to said first node, a first voltage drop element having a threshold voltage and connected between said third node and a second power terminal, a third transistor connected in parallel to said first voltage drop element, and a drive circuit driving said third transistor by a drive signal having a phase opposite to a signal derived from said second node.

2. The buffer circuit as claimed in claim 1, wherein said first voltage drop element comprises a fourth transistor having a gate connected to said third node.

3. The buffer circuit as claimed in clam 1, wherein said first voltage drop element comprises a plurality of transistors each operating a diode.

4. The buffer circuit as claimed in claim 2, wherein said drive circuit comprises an inverter connected between said second node and a gate of said third transistor.

5. The buffer circuit as claimed in claim 1, further comprising a second voltage drop element inserted between said first transistor and said first power terminal and a fourth transistor connected in parallel to said second voltage drop element, said fourth transistor being driven by said drive signal.

6. The buffer circuit as claimed in claim 5, wherein each of said first and second voltage drop elements comprises a diode-connected transistor.

7. The buffer circuit as claimed in claim 5, wherein said drive circuit comprises an inverter having an input end connected between said second node and an output end connected in common to gates of said third and fourth transistors.

8. A buffer circuit comprising an input node supplied with an input signal, a first transistor connected between a first power terminal and a circuit node and having a gate connected to said input node, a second transistor connected between said circuit node and a second power terminal and having a gate connected to said input node, a third transistor inserted between said first transistor and said first power terminal and operating a diode, a fourth transistor inserted between said first transistor and said first power terminal in parallel to said third transistor, an output node connected to a gate of said fourth transistor, and an inverter having an input end connected to said circuit node and an output end connected to said output node.

9. The circuit as claimed in claim 8, further comprising a fifth transistor inserted between said second transistor and said second power terminal and operating a diode and a sixth transistor inserted between said second transistor and said second power terminal in parallel to said fifth transistor and having a gate connected to said output node.
